(19) Europäisches Patentamt
European Patent Office
Office européen des brevets

(11) **EP 2 833 372 A1**

(12) **EUROPÄISCHE PATENTANMELDUNG**

(43) Veröffentlichungstag:
**04.02.2015 Patentblatt 2015/06**

(51) Int Cl.:
***H01C 1/06*** (2006.01)

(21) Anmeldenummer: **14002394.6**

(22) Anmeldetag: **11.07.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **31.07.2013 DE 102013012733**

(71) Anmelder: **Forschungszentrum Jülich GmbH 52425 Jülich (DE)**

(72) Erfinder:
• **Morawski, Ireneusz**
**50-204 Wroclaw (PL)**
• **Voigtländer, Bert**
**52428 Jülich (DE)**

(54) **Widerstand mit verminderter parasitärer Kapazität**

(57) Im Rahmen der Erfindung wurde ein elektrischer Widerstand mit zwei elektrisch leitfähigen Elektroden und mindestens einem resistiven Element, das einen Strompfad zwischen den beiden elektrisch leitfähigen Elektroden bereitstellt, entwickelt. Erfindungsgemäß ist bei diesem Widerstand ein elektrisch leitendes oder halbleitendes Abschirmelement, das mit einem Ladungsreservoir verbunden ist, mindestens teilweise in einem Bereich angeordnet, in dem ein durch Anlegen einer Spannung über den Widerstand erzeugtes elektrisches Feld mindestens 20 %, bevorzugt mindestens 50 % und ganz besonders bevorzugt mindestens 80 % der Maximalfeldstärke aufweist, die dieses Feld auf einer zur kürzesten Verbindungslinie zwischen den elektrisch leitfähigen Elektroden senkrechten und entlang dieser Verbindungslinie mittig zwischen den elektrisch leitfähigen Elektroden angeordneten Ebene hat.

Es wurde erkannt, dass die beiden elektrisch leitfähigen Elektroden des Widerstands in erster Näherung als Platten eines Plattenkondensators wirken, der die parasitäre Kapazität des Widerstands verkörpert. Das Abschirmelement wird bei Aufladung einer der Elektroden des Widerstands mit einer zu dieser Aufladung entgegengesetzten Ladung belegt und sorgt dafür, dass zumindest ein Teil der von dieser Elektrode ausgehenden Feldlinien an dem Abschirmelement endet statt an der zweiten Elektrode. Dadurch wird die gleichzeitige Aufladung beider Elektroden mit betragsmäßig gleichen, aber entgegengesetzten Ladungen erschwert.

Figur 1

EP 2 833 372 A1

**Beschreibung**

Die Erfindung betrifft einen elektrischen Widerstand mit verminderter parasitärer Kapazität.

Stand der Technik

Jeder reale elektrische Widerstand ist kein reiner Widerstand R, sondern weist auch eine parasitäre Kapazität Cp auf, die mit dem Widerstand R parallelgeschaltet ist und im Wesentlichen durch die metallischen Anschlussleitungen verursacht wird. Damit hat der reale Widerstand einen komplexen Wechselstromwiderstand (Impedanz) Z von

$$ Z = \frac{R}{1 + i\omega R C_p}, $$

die oberhalb einer Grenzfrequenz $f_c$ von

$$ f_c = \frac{1}{2\pi R C_p} $$

drastisch abnimmt. Der Wert von Cp hängt sowohl vom geometrischen Aufbau des Widerstands als auch von den verwendeten Materialien ab.

Für Messungen sehr kleiner Stromsignale können Widerstandswerte von 100 MΩ und mehr erforderlich sein, was über die Grenzfrequenz $f_c$ die nutzbare Bandbreite auf einige 10 kHz einschränkt. Bei 100 GΩ ist selbst mit dem speziell auf eine niedrige parasitäre Kapazität Cp von 60 fF optimierten SMD-Widerstand der 0603-Serie nur noch eine Grenzfrequenz $f_c$ von 26 Hz nutzbar.

Um den Einfluss der parasitären Kapazität Cp auf die Schaltung zu reduzieren, sind verschiedene Kompensationstechniken bekannt, bei denen zusätzliche Widerstände, Kapazitäten und/oder aktive Bauelemente (Transistoren oder Operationsverstärker) in die Schaltung eingefügt werden. Nachteilig holt man sich hierdurch zusätzliches Rauschen in die Schaltung und benötigt zum Teil auch den genauen Wert der zu kompensierenden parasitären Kapazität Cp. Darüber hinaus funktioniert die Kompensation in der Regel immer nur in einem begrenzten Frequenzbereich.

Aufgabe und Lösung

Es ist daher die Aufgabe der Erfindung, einen elektrischen Widerstand zur Verfügung zu stellen, der eine geringere parasitäre Kapazität aufweist als Widerstände nach dem bisherigen Stand der Technik.

Diese Aufgabe wird erfindungsgemäß gelöst durch einen Widerstand gemäß Hauptanspruch und Nebenansprüchen. Weitere vorteilhafte Ausgestaltungen ergeben sich aus den darauf rückbezogenen Unteransprüchen.

Gegenstand der Erfindung

Im Rahmen der Erfindung wurde ein elektrischer Widerstand mit zwei elektrisch leitfähigen Elektroden (Anschlüssen) und mindestens einem resistiven Element, das einen Strompfad zwischen den beiden elektrisch leitfähigen Elektroden bereitstellt, entwickelt. Die elektrisch leitfähigen Elektroden können insbesondere metallisch oder halbleitend sein. Erfindungsgemäß ist bei diesem Widerstand ein elektrisch leitendes oder halbleitendes Abschirmelement vorgesehen, das mit einem Ladungsreservoir verbunden ist und bei Aufladung einer der elektrisch leitfähigen Elektroden mindestens 20 %, bevorzugt mindestens 50 % und ganz besonders bevorzugt mindestens 80 % des durch die Aufladung bewirkten elektrischen Flusses von der anderen elektrisch leitfähigen Elektrode fernhält.

Es wurde erkannt, dass die parasitäre Kapazität des Widerstands genauso funktioniert wie jeder Plattenkondensator: Es wird Energie gespeichert, indem beide Elektroden entgegengesetzt gleich aufgeladen werden. Dies wird durch Anlegen einer Spannung über den Kondensator bewirkt. Die Spannung ist in Ladung verkörpert, die auf eine Elektrode aufgebracht wird und einen von dieser Elektrode ausgehenden elektrischen Fluss bewirkt. Dieser Fluss besteht aus elektrischen Feldlinien, die auf der aufgeladenen Elektrode beginnen und auf der anderen Elektrode enden. Er führt zur entgegengesetzten Aufladung der anderen Elektrode.

Der Fluss verändert sich nun drastisch, wenn das Abschirmelement eingeführt und mit einem Ladungsreservoir verbunden wird. Viele elektrische Feldlinien, die an der aufgeladenen Elektrode beginnen, enden nun nicht mehr an der anderen Elektrode, sondern auf dem Abschirmelement. Indem also das Abschirmelement mindestens einen Teil des durch die Aufladung bewirkten elektrischen Flusses von der anderen Elektrode fernhält, wird diese andere Elektrode weniger aufgeladen. Die Fähigkeit des Widerstands, Energie zu speichern, wird dadurch beeinträchtigt. Somit wird seine parasitäre Kapazität vermindert. Je größer der Anteil des elektrischen Flusses ist, der von der anderen Elektrode ferngehalten wird, desto stärker ist die Minderung der parasitären Kapazität. Diese Minderung ist also ein gradueller Effekt, kein on-off-Effekt.

Im Rahmen der Erfindung wurde ein elektrischer Widerstand mit zwei elektrisch leitfähigen Elektroden (Anschlüssen) und mindestens einem resistiven Element, das einen Strompfad zwischen den beiden elektrisch leitfähigen Elektroden bereitstellt, entwickelt. Die elektrisch leitfähigen Elektroden können insbesondere metallisch oder halbleitend sein. Erfindungsgemäß ist bei diesem Widerstand ein elektrisch leitendes oder halbleitendes Abschirmelement, das mit einem Ladungsreservoir verbunden ist, mindestens teilweise in einem Bereich angeordnet, in dem ein durch Anlegen einer Spannung über den Widerstand erzeugtes elektrisches Feld mindestens 20 %, bevorzugt mindestens 50 % und ganz besonders bevorzugt mindestens 80 % der Maximalfeldstärke aufweist, die dieses Feld auf einer zur kürzesten Verbindungslinie zwischen den elektrisch leitfähigen Elektroden senkrechten und entlang dieser Verbindungslinie mittig zwischen den elektrisch leitfähigen Elektroden angeordneten Ebene hat.

Unter einer Verbindungslinie wird in diesem Zusammenhang eine gerade Linie zwischen einem Punkt auf der ersten elektrisch leitfähigen Elektrode und einem Punkt auf der zweiten elektrisch leitfähigen Elektrode verstanden. Da die elektrisch leitfähigen Elektroden in der Regel räumlich ausgedehnt sind, gibt es viele verschiedene Verbindungslinien.

Unter einem Ladungsreservoir wird ein Ort verstanden, unter dem das Abschirmelement mit geringer Impedanz, bevorzugt mit weniger als 1 % der zwischen den elektrisch leitfähigen Elektroden bestehenden Impedanz, Ladungen austauschen kann, und zwar bevorzugt mindestens das 10-Fache und ganz besonders bevorzugt mindestens das 100-Fache der Ladungsmenge, auf die jede der beiden elektrisch leitfähigen Elektroden aufladbar ist. Das Ladungsreservoir sollte ein möglichst geringes Rauschen in die Schaltung abgeben.

In einer besonders vorteilhaften Ausgestaltung der Erfindung ist das Abschirmelement elektrisch gegen die beiden elektrisch leitfähigen Elektroden isoliert. Dadurch wird eine unerwünschte gegenseitige Beeinflussung zwischen dem Ladungsreservoir und der Schaltung, in die der elektrische Widerstand integriert ist, vermieden.

Die mittig zwischen den elektrisch leitfähigen Elektroden angeordnete Ebene ist nicht als in der Weise ausgezeichnet anzusehen, dass das Abschirmelement speziell in dieser Ebene verlaufen sollte. Sie dient lediglich zur Definition eines Querschnitts der Feldverteilung, die sich beim Anlegen einer Spannung zwischen den beiden elektrisch leitfähigen Elektroden des Widerstands aufbaut, unter Ausschluss von Randeffekten in unmittelbarer Nähe der elektrisch leitfähigen Elektroden.

Es wurde erkannt, dass die beiden elektrisch leitfähigen Elektroden des Widerstands in erster Näherung als Platten eines Plattenkondensators wirken, der die parasitäre Kapazität des Widerstands verkörpert. Diese Kapazität ist deutlich größer, in der Regel um mindestens eine Größenordnung größer, als die Kapazität des resistiven Strompfads. In dem Kondensator, den die elektrisch leitfähigen Elektroden bilden, wird Energie gespeichert, indem beide Platten (elektrisch leitfähige Elektroden) mit entgegengesetztem Vorzeichen aufgeladen werden, so dass sich ein elektrisches Feld zwischen den beiden Platten aufbaut. Das Abschirmelement wird nun bei Aufladung einer der elektrisch leitfähigen Elektroden des Widerstands mit einer zu dieser Aufladung entgegengesetzten Ladung belegt und sorgt dafür, dass zumindest ein Teil der von dieser elektrisch leitfähigen Elektrode ausgehenden Feldlinien an dem Abschirmelement endet, statt an der zweiten elektrisch leitfähigen Elektrode. Dadurch wird die gleichzeitige Aufladung beider elektrisch leitfähiger Elektroden mit betragsmäßig gleichen, aber entgegengesetzten Ladungen erschwert. Somit wird die parasitäre Kapazität des Widerstands drastisch reduziert.

Wie groß dieser Effekt ist, hängt davon ab, welcher Anteil der Feldlinien auf das Abschirmelement umgelenkt wird. Dies wiederum hängt von der elektrischen Feldstärke an dem Ort ab, an dem das Abschirmelement angeordnet ist. Der Effekt ist also kein on-off-Effekt, sondern setzt graduell ein. Er erreicht eine technisch nutzbare Größenordnung, wenn das Abschirmelement im beanspruchten Bereich angeordnet ist. Er wird besonders stark, wenn das Abschirmelement mindestens teilweise auf einer direkten Verbindungslinie zwischen den beiden elektrisch leitfähigen Elektroden angeordnet ist und/oder mindestens eine solche direkten Verbindungslinie verdeckt und/oder unterbricht, und am stärksten, wenn es jede direkte Verbindungslinie zwischen den beiden elektrisch leitfähigen Elektroden verdeckt und/oder unterbricht.

Das Abschirmelement kann aber auch abseits der direkten Verbindungslinie zwischen den beiden elektrisch leitfähigen Elektroden angeordnet sein. Ein herkömmlicher Widerstand lässt sich durch Hinzufügen eines Abschirmelements zu dieser Ausführungsform umrüsten, ohne am Widerstand selbst etwas zu ändern. Dies ist besonders vorteilhaft, wenn die elektrisch leitfähigen Elektroden und das resistive Element an ein dielektrisches Substrat gekoppelt sind, das sich zwischen beiden elektrisch leitfähigen Elektroden erstreckt, was insbesondere für SMD-Widerstände eine übliche Bauform ist. Das Substrat muss dann nicht angetastet werden, um das Abschirmelement hinzuzufügen. Dafür ist der Abschirmeffekt tendenziell schwächer, weil sich das elektrische Feld bzw. der elektrische Fluss zwischen den beiden elektrisch leitfähigen Elektroden größtenteils im Bereich der direkten Verbindungslinien zwischen den elektrisch leitfähigen Elektroden ausbildet. Vorteilhaft führt es daher zumindest teilweise in einer Entfernung von höchstens der doppelten, bevorzugt höchstens der einfachen, größten räumlichen Ausdehnung der elektrisch leitfähigen Elektroden an einer solchen Verbindungslinie vorbei. Die größte räumliche Ausdehnung einer elektrisch leitfähigen Elektrode ist der größte lineare Abstand, den zwei Punkte auf dieser elektrisch leitfähigen Elektrode haben können.

Das Abschirmelement kann beispielsweise ringförmig ausgestaltet sein, wobei mindestens eine Verbindungslinie zwischen den beiden elektrisch leitfähigen Elektroden durch die von ihm umgrenzte Fläche hindurchtritt. Dabei ändert sich die Wirkung des Abschirmelements in weiten Bereichen nur um wenige Prozent, wenn ein den Widerstand umgebendes ringförmiges Abschirmelement entlang der Längsachse des Widerstands (direkte Verbindungslinie zwischen den beiden Elektroden) verschoben wird. Das ringförmige Abschirmelement muss nicht als separates Teil realisiert sein, sondern es kann beispielsweise auch auf das dielektrische Substrat strukturiert sein, etwa als ringförmige Metallisierung. Dann kann ein besonders großer Anteil der Feldlinien auf das Abschirmelement umgelenkt werden.

Vorteilhaft ist eine Ankopplung an ein konstantes Potential, insbesondere an ein Massepotential, als Ladungsreservoir vorgesehen. Innerhalb der Schaltung kann dieses Potential dann für mehrere erfindungsgemäße Widerstände als Ladungsreservoir genutzt werden. Dabei ist pro Widerstand nur eine elektrische Verbindung zu diesem Potential erforderlich und nicht jeweils ein eigenes Ladungsreservoir. Das Massepotential kann insbesondere dasjenige sein, auf das der Eingang für das mit dem Widerstand zu messende Signal bezogen ist. Wird beispielsweise das Signal mit einem Koaxialkabel zugeführt, so ist die Seele (Innenleiter) dieses Kabels mit dem Eingang verbunden und der Außenleiter mit dem Massepotential, auf das dieser Eingang bezogen ist.

Vorteilhaft umfasst der Widerstand mindestens zwei in Reihe geschaltete Widerstände, beispielsweise zwei handelsübliche SMD-Widerstände, die in der Summe den gewünschten Widerstandswert ergeben. Dann sind auch die parasitären Kapazitäten der beiden Widerstände in Reihe geschaltet. Während sich die Widerstandswerte $R_1$ und $R_2$ zu $R=R_1+R_2$ addieren, setzen sich die parasitären Kapazitäten $C_1$ und $C_2$ der Einzelwiderstände gemäß $1/C_p=1/C_1+1/C_2$ zur gesamten parasitären Kapazität des Widerstands zusammen. Sind $C_1$ und $C_2$ gleich, wird damit bei gleichem Gesamtwiderstand R die parasitäre Kapazität Cp halbiert, was in den Versuchen der Erfinder auch beobachtet wurde.

Dieser Effekt lässt sich auch dadurch erklären, dass der Widerstand durch die Reihenschaltung mechanisch verlängert wird; der Abstand zwischen den elektrisch leitfähigen Elektroden nimmt zu. Die Kapazität eines Plattenkondensators ist proportional zur Plattenfläche, aber umgekehrt proportional zum Plattenabstand. Daher nimmt die parasitäre Kapazität ab, wenn der Widerstand als Reihenschaltung mehrerer Widerstände realisiert ist. Qualitativ wird diese Näherung, die das elektrische Feld nur entlang direkter Verbindungslinien zwischen den elektrisch leitfähigen Elektroden verlaufen lässt und Streufelder abseits dieser Verbindungslinien völlig vernachlässigt, um so schlechter, je größer der Abstand zwischen den elektrisch leitfähigen Elektroden gegenüber den Abmessungen der elektrisch leitfähigen Elektroden ist.

In einer besonders vorteilhaften Ausgestaltung der Erfindung ist das Abschirmelement der Reihenschaltung ohne Modifikation der Widerstände, aus denen sie zusammengesetzt ist, hinzugefügt. Es kann beispielsweise zwischen den beiden Widerständen angeordnet sein. Es kann beispielsweise auch ein ringförmiges Element sein, das einen der beiden Widerstände umgibt.

In einer weiteren besonders vorteilhaften Ausgestaltung der Erfindung beträgt das Verhältnis des Abstands zwischen den elektrisch leitfähigen Elektroden zur größten räumlichen Ausdehnung einer elektrisch leitfähigen Elektrode mindestens 2, bevorzugt mindestens 5 und ganz besonders bevorzugt mindestens 10. Für die Wirkung der mechanischen Verlängerung des Widerstands auf die parasitäre Kapazität ist es unerheblich, ob auf der gleichen Länge ein einzelner Widerstand oder eine Reihenschaltung mit gleichem Widerstandswert realisiert ist. Man kann sich den Einzelwiderstand als Reihenschaltung denken und kommt zum gleichen Ergebnis.

Es wurde erkannt, dass die Verlängerung des Widerstands speziell mit einem abseits der direkten Verbindungslinien zwischen den elektrisch leitfähigen Elektroden angeordneten Abschirmelement, das beispielsweise den Widerstand ringförmig umgibt, synergistisch zusammenwirkt. Je länger der Widerstand ist, desto größer sind die Streufelder abseits der direkten Verbindungslinien. Gerade die Feldlinien dieser Streufelder werden aber auf das Abschirmelement umgelenkt, so dass sie nichts mehr zur parasitären Kapazität beitragen. Bewirkt eine Reihenschaltung zweier Widerstände (oder eine entsprechende Verlängerung eines Einzelwiderstands) allein eine Halbierung der parasitären Kapazität und bewirkt ein ringförmiges Abschirmelement allein ebenfalls eine Halbierung, verringert die Kombination beider Maßnahmen die parasitäre Kapazität nach den experimentellen Ergebnissen der Erfinder nicht um einen Faktor 4, sondern um einen Faktor 20. Dieses Ergebnis lässt sich nicht analytisch herleiten, da es für die Streufelder keine geschlossene Formel gibt. Der genaue Feldverlauf zwischen den elektrisch leitfähigen Elektroden muss numerisch, etwa mit der Finite-Elemente-Methode, bestimmt werden.

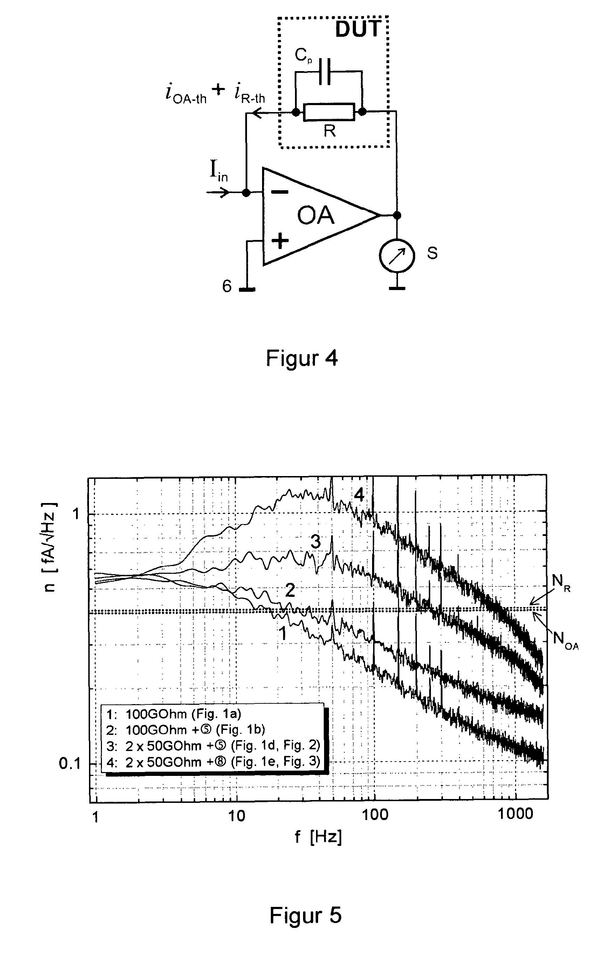

Eine wichtige Anwendung des erfindungsgemäßen Widerstands ist die Messung sehr kleiner Ströme mit einem Strom-Spannungs-Wandler der in Figur 4 gezeigten Bauart. Wird der zu messende Strom $I_{in}$ in den invertierenden Eingang des Operationsverstärkers eingekoppelt und ist dieser mit einem realen Widerstand zurückgekoppelt, der einen nominellen Widerstand R und eine parasitäre Kapazität Cp hat, ist die frequenzabhängige Ausgangsspannung $U_{out}(\omega)$ gegeben durch

$$\left|U_{out}(\omega)\right| = \frac{I_{in} \cdot R}{\sqrt{1 + \omega^2 R^2 C_p^2}},$$

wobei der Operationsverstärker als ideales Bauelement angenommen wurde. Die Größenordnung des benötigten Widerstands R lässt sich abschätzen, indem $\omega=0$ gesetzt wird: die Ausgangsspannung $U_{out}$ ist dann $I_{in}*R$. Je

kleiner der zu messende Strom $I_{in}$ ist, desto größer ist also der benötigte Widerstand. Soll ein Strom $I_{in}$ von 10 pA eine Ausgangsspannung $U_{out}$ von 1 V bewirken, ist also ein Widerstand R von 100 GΩ erforderlich. Indem erfindungsgemäß Cp vermindert wird, wird die Grenzfrequenz $f_c$ und damit auch die für die Messung von Wechselstromsignalen nutzbare Bandbreite vorteilhaft stark erhöht.

Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:

Figur 1: Verschiedene Ausführungsbeispiele des erfindungsgemäßen Widerstands in schematischer Darstellung.

Figur 2: Praktische Realisierung des in Figur 1c skizzierten Ausführungsbeispiels.

Figur 3: Praktische Realisierung eines weiteren Ausführungsbeispiels.

Figur 4: Messanordnung zur indirekten Messung der parasitären Kapazität über das übertragene Rauschspektrum.

Figur 5: Mit der Messanordnung nach Figur 4 erhaltene Messergebnisse für verschiedene Widerstände.

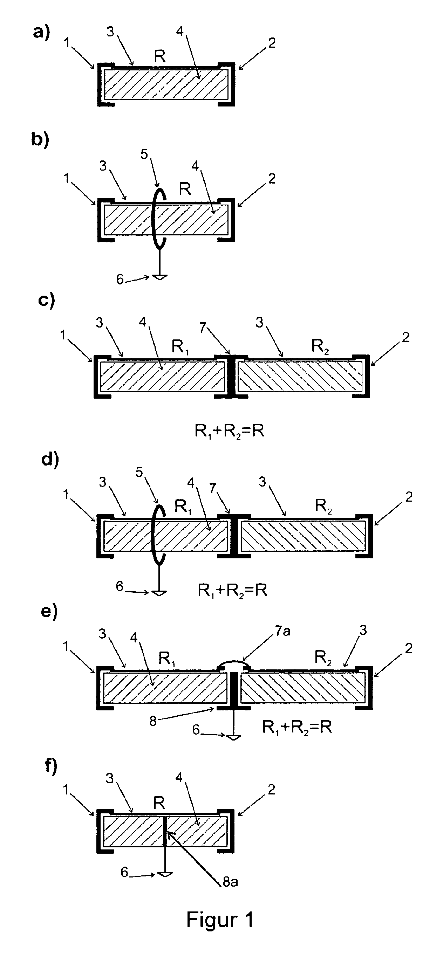

Figur 1a zeigt den schematischen Aufbau eines SMD-Widerstands mit nominellem Widerstandswert R, der gemäß der Erfindung zum Widerstand mit geringer parasitärer Kapazität umgerüstet wird. Der SMD-Widerstand umfasst zwei metallische Anschlüsse (elektrisch leitfähige Elektroden) 1 und 2, die durch einen resistiven Strompfad 3 elektrisch verbunden sind. Sowohl die elektrisch leitfähigen Elektroden 1 und 2 als auch der Strompfad 3 werden von einem dielektrischen Substrat 4 aus Aluminiumoxid $Al_2O_3$ getragen.

Figur 1b zeigt einen erfindungsgemäßen Widerstand mit einem ringförmigen Abschirmelement 5, das den Widerstand gemäß Figur 1a umgibt. Die Verbindungslinien zwischen den elektrisch leitfähigen Elektroden 1 und 2 treten also durch die von dem Abschirmelement 5 umgrenzte Fläche hindurch. Das Abschirmelement 5 verläuft eng um den Widerstand und damit auch um die direkten Verbindungslinien zwischen den beiden elektrisch leitfähigen Elektroden 1 und 2. Es verläuft nirgendwo weiter als die größte Ausdehnung einer der elektrisch leitfähigen Elektroden von der nächsten direkten Verbindungslinie entfernt. Das Abschirmelement 5 ist mit dem lokalen Massepotential 6 als Ladungsreservoir verbunden. Dieses Potential tauscht mit dem Abschirmelement 5 mit sehr geringer Impedanz Ladungen aus, beaufschlagt es jedoch kaum mit Rauschen. Die parasitäre Kapazität ist gegenüber dem Widerstand gemäß Figur 1a um etwa einen Faktor 2 reduziert.

Figur 1c zeigt eine Reihenschaltung zweier Widerstände $R_1$ und $R_2$ von der Bauart des Widerstands gemäß Figur 1a. Diese Reihenschaltung hat den gleichen nominellen Widerstandswert wie der Widerstand gemäß Figur 1a. Indem sie den Abstand zwischen den beiden elektrisch leitfähigen Elektroden 1 und 2 verdoppelt, reduziert sie die parasitäre Kapazität etwa um einen Faktor 2. Die jeweils anderen Elektroden der Einzelwiderstände $R_1$ und $R_2$, die gemeinsam eine Innenelektrode 7 bilden, reduzieren die parasitäre Kapazität nicht, da diese Innenelektrode 7 auf einem frei schwebenden (floating) Potential ist.

Figur 1d zeigt die Kombination der in Figur 1c gezeigten Reihenschaltung mit dem ringförmigen Abschirmelement gemäß Figur 1b, das den linken der beiden Widerstände umgibt und mit dem lokale Massepotential 6 als Ladungsreservoir verbunden ist. Die Kombination der Reihenschaltung mit dem Abschirmelement reduziert die parasitäre Kapazität um etwa einen Faktor 20.

Figur 1e zeigt ein weiteres Ausführungsbeispiel des erfindungsgemäßen Widerstands. Die Reihenschaltung gemäß Figur 1c wurde dahingehend modifiziert, dass der Kontakt der gemeinsamen Innenelektrode 7 zu den resistiven Strompfaden 3 unterbrochen und diese stattdessen mit dem lokalen Massepotential 6 als Ladungsreservoir verbunden wurde. Sie wurde dadurch zu einem Abschirmelement 8, das fast alle direkten Verbindungslinien zwischen den beiden elektrisch leitfähigen Elektroden verdeckt und unterbricht. Die Verbindung zwischen den beiden resistiven Strompfaden 3 wurde durch eine Drahtbrücke 7a, die keinen Kontakt zum Abschirmelement 8 hat, wieder hergestellt.

Figur 1f zeigt ein weiteres Ausführungsbeispiel des erfindungsgemäßen Widerstands. Der Widerstand gemäß Figur 1a wurde zu diesem Ausführungsbeispiel umgerüstet, indem das mit dem lokalen Massepotential 6 als Ladungsreservoir verbundene Abschirmelement 8a in die Mitte des Substrats 4 eingebracht wurde. Es verdeckt und unterbricht fast alle direkten Verbindungslinien zwischen den beiden elektrisch leitfähigen Elektroden 1 und 2. Entsprechend stark ist seine Wirkung; die parasitäre Kapazität des Widerstands ist gegenüber dem ursprünglichen Widerstand gemäß Figur 1a um etwa einen Faktor 100 reduziert.

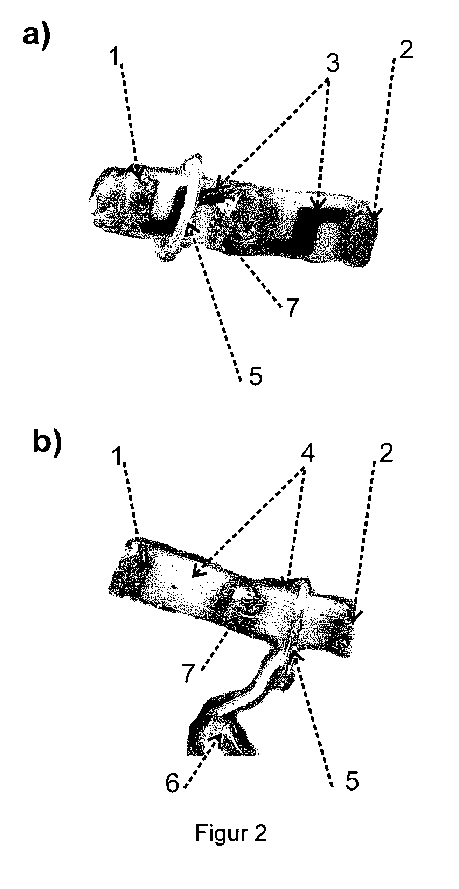

Figur 2 zeigt eine praktische Realisierung des in Figur 1c skizzierten Ausführungsbeispiels in Vorderansicht (Figur 2a) und in rückwärtiger Ansicht (Figur 2b). Die Elektrode 1 des Widerstands ist mit dem Ausgang eines Operationsverstärkers in einer Verstärkerschaltung verbunden; die Elektrode 2 des Widerstands ist mit dem invertierenden Eingang des Operationsverstärkers verbunden. Der Widerstand befindet sich also in der Rückkoppelschleife der Verstärkerschaltung. Er ist als Reihenschaltung aus zwei SMD-Widerständen $R_1$ und $R_2$ realisiert, die jeweils ein Substrat 4 und einen S-förmigen resistiven Strompfad 3 beinhalten. Dabei ist der Widerstand $R_1$ von dem ringförmigen Abschirmelement 5 umgeben, das mit dem lokalen Massepotential 6 als Ladungsreservoir verbunden ist. Beide Widerstände sind über eine Lötstelle 7 miteinander verbunden, die die gemeinsame Innenelektrode bildet. Diese liegt auf einem frei schwebenden (floating) Potential und vermindert daher die parasitäre Kapazität nicht.

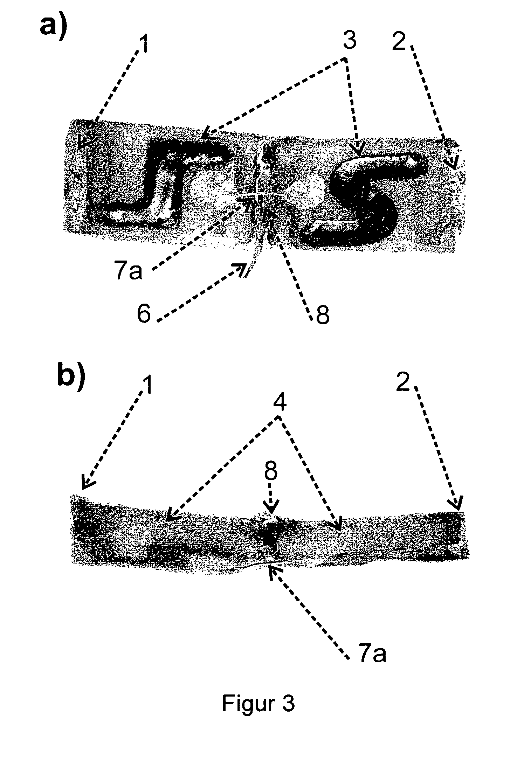

Figur 3 zeigt eine praktische Realisierung des in Figur 1e gezeigten Ausführungsbeispiels des erfindungsgemäßen Widerstands. Figur 3a zeigt eine Aufsicht, Figur 3b zeigt eine Seitenansicht. Die beiden Widerstände, die jeweils ein Substrat 4 und einen resistiven Strompfad 3 umfassen, sind über eine Drahtbrücke 7a miteinander verbunden. Die Reihenschaltung als Ganzes ist über die elektrisch leitfähigen Elektroden 1 und 2 mit der Außenwelt kontaktiert. Zwischen den Widerständen $R_1$ und $R_2$ ist das Abschirmelement 8 angeordnet, das mit dem lokalen Massepotential 6 als Ladungsreservoir verbunden ist. Das Abschirmelement 8 hat keinen Kontakt zu der Drahtbrücke 7 oder zu einem der resistiven Strompfade 3.

Figur 4 zeigt eine Messschaltung, mit der das Rauschspektrum verschiedener Widerstände als Maß für die Nutzbarkeit bei hohen Frequenzen aufgezeichnet wurde. Der Widerstand als Messobjekt (Device Under Test, DUT) ist hier als das Ersatzschaltbild aus seinem nominellen Widerstand R und seiner parasitären Kapazität Cp eingezeichnet. Er befindet sich in der Rückkoppelschleife eines invertierend beschalteten Operationsverstärkers (OA) vom Typ OPA111. Der nicht invertierende Eingang ist mit dem lokalen Massepotential 6 verbunden; der invertierende Eingang erhält nur das Eingangsrauschen $i_{OA-th}$ des Operationsverstärkers und das thermische Rauschen $i_{R-th}$ des untersuchten Widerstands. Beide Ströme addieren sich zu einem resultierenden Strom $I_{in}$, der statistisch um einen Mittelwert von Null schwankt. Die Spannung am Ausgang des Operationsverstärkers wird über einen Spektrumanalysator S frequenzabhängig gemessen.

Figur 5 zeigt die an verschiedenen Widerständen, die jeweils einen nominellen Widerstandswert von 100 GΩ haben, gemessenen Stromrauschdichten n in

$$\mathrm{fA}/\sqrt{\mathrm{Hz}},$$

aufgetragen über der Frequenz f in Hz. Die Bandbreite, mit der dieses Stromrauschen übertragen wird, wird als indirektes Maß für die parasitäre Kapazität Cp des Widerstands herangezogen, da für extrem kleine Kapazitäten im Femtofarad-Bereich keine direkten Messmittel zur Verfügung stehen. Kurve 1 ist an dem in Figur 1a skizzierten herkömmlichen Widerstand gemessen worden, Kurve 2 an dem gleichen Widerstand, der mit einem ringförmigen Abschirmelement gemäß Figur 1b zum erfindungsgemäßen Widerstand umgerüstet wurde. Kurve 3 ist an einer Reihenschaltung zweier herkömmlicher 50-GΩ-Widerstände gemäß Figur 1c, die durch Hinzufügung eines ringförmigen Abschirmelements in das Ausführungsbeispiel gemäß Figur 1d aufgerüstet wurde, gemessen worden. Kurve 4 ist an der in Figur 1c gezeigten und durch Erdung der Innenelektrode 7 zum erfindungsgemäßen Widerstand umgerüsteten Reihenschaltung gemessen worden (Ausführungsbeispiel gemäß Figur 3).

Die Grenzfrequenz $f_c$ ist in erster Näherung umgekehrt proportional zur parasitären Kapazität Cp. Dass die verbesserten Widerstände gegenüber dem herkömmlichen Widerstand (Kurve 1) deutlich mehr Frequenzen durchlassen, ist somit ein sichtbares Zeichen einer verminderten parasitären Kapazität. Da die parasitäre Kapazität Cp des untersuchten Widerstands mit der Eingangskapazität $C_{in}$ des Operationsverstärkers in Reihe geschaltet ist, lässt sich für höhere Frequenzen zusätzlich noch ein Ansteigen der Verstärkung beobachten, das für höhere Frequenzen proportional zu $C_{in}/C_p$ ist. Für tiefe Frequenzen unterhalb von wenigen Hz dagegen wird das Rauschen durch das thermische Rauschen $N_R$ des resistiven Strompfads selbst und durch das Eingangsrauschen $N_{OA}$ des Operationsverstärkers bestimmt.

**Patentansprüche**

1. Elektrischer Widerstand mit zwei elektrisch leitfähigen Elektroden und mindestens einem resistiven Element, das einen Strompfad zwischen den beiden elektrisch leitfähigen Elektroden bereitstellt,
   **dadurch gekennzeichnet, dass**
   ein elektrisch leitendes oder halbleitendes Abschirmelement vorgesehen ist, das mit einem Ladungsreservoir verbunden ist und bei Aufladung einer der elektrisch leitfähigen Elektroden mindestens 20 %, bevorzugt mindestens 50 % und ganz besonders bevorzugt mindestens 80 % des durch die Aufladung bewirkten elektrischen Flusses von der anderen elektrisch leitfähigen Elektrode fernhält.

2. Elektrischer Widerstand mit zwei elektrisch leitfähigen Elektroden und mindestens einem resistiven Element, das einen Strompfad zwischen den beiden elektrisch leitfähigen Elektroden bereitstellt,
   **dadurch gekennzeichnet, dass**
   ein elektrisch leitendes oder halbleitendes Abschirmelement, das mit einem Ladungsreservoir verbunden ist, mindestens teilweise in einem Bereich angeordnet ist, in dem ein durch Anlegen einer Spannung über den Widerstand erzeugtes elektrisches Feld mindestens 20 %, bevorzugt mindestens 50 % und ganz besonders bevorzugt mindestens 80 % der Maximalfeldstärke aufweist, die dieses Feld auf einer zur kürzesten Verbindungslinie zwischen den elektrisch leitfähigen Elektroden senkrechten und entlang dieser Verbindungslinie mittig zwischen den elektrisch leitfähigen Elektroden angeordneten Ebene hat.

3. Elektrischer Widerstand mit zwei elektrisch leitfähigen Elektroden und mindestens einem resistiven Element, das einen Strompfad zwischen den beiden elektrisch leitfähigen Elektroden bereitstellt, **dadurch gekennzeichnet, dass**

ein elektrisch leitendes oder halbleitendes Abschirmelement, das mit einem Ladungsreservoir verbunden ist,

• mindestens teilweise auf einer direkten Verbindungslinie zwischen den beiden elektrisch leitfähigen Elektroden angeordnet ist und/oder mindestens eine solche Verbindungslinie verdeckt und/oder unterbricht, und/oder
• zumindest teilweise in einer Entfernung von höchstens der doppelten, bevorzugt höchstens der einfachen, größten räumlichen Ausdehnung der elektrisch leitfähigen Elektroden an einer solchen Verbindungslinie vorbeiführt.

4. Widerstand nach einem der Ansprüche 1 bis 3, **dadurch gekennzeichnet, dass** das Abschirmelement elektrisch gegen die beiden elektrisch leitfähigen Elektroden isoliert ist.

5. Widerstand nach einem der Ansprüche 1 bis 4, **dadurch gekennzeichnet, dass** das Abschirmelement jede direkte Verbindungslinie zwischen den beiden elektrisch leitfähigen Elektroden verdeckt.

6. Widerstand nach einem der Ansprüche 1 bis 5, **dadurch gekennzeichnet, dass** das Abschirmelement ringförmig ist und mindestens eine Verbindungslinie zwischen den beiden elektrisch leitfähigen Elektroden durch die von ihm umgrenzte Fläche hindurchtritt.

7. Widerstand nach einem der Ansprüche 1 bis 6, **dadurch gekennzeichnet, dass** eine Ankopplung an ein konstantes Potential, insbesondere an ein Massepotential, als Ladungsreservoir vorgesehen ist.

8. Widerstand nach einem der Ansprüche 1 bis 7, **dadurch gekennzeichnet, dass** die elektrisch leitfähigen Elektroden und das resistive Element an ein dielektrisches Substrat gekoppelt sind, das sich zwischen beiden elektrisch leitfähigen Elektroden erstreckt.

9. Widerstand nach einem der Ansprüche 1 bis 8, **dadurch gekennzeichnet, dass** er mindestens zwei in Reihe geschaltete Widerstände umfasst.

10. Widerstand nach Anspruch 9, **dadurch gekennzeichnet, dass** das Abschirmelement der Reihenschaltung ohne Modifikation der Widerstände, aus denen sie zusammengesetzt ist, hinzugefügt ist.

11. Widerstand nach einem der Ansprüche 1 bis 10, **dadurch gekennzeichnet, dass** das Verhältnis des Abstands zwischen den elektrisch leitfähigen Elektroden zur größten räumliche Ausdehnung einer elektrisch leitfähigen Elektrode mindestens 2, bevorzugt mindestens 5 und ganz besonders bevorzugt mindestens 10 beträgt.

**a)**

**b)**

**c)**

$$R_1 + R_2 = R$$

**d)**

$$R_1 + R_2 = R$$

**e)**

$$R_1 + R_2 = R$$

**f)**

Figur 1

a)

b)

Figur 2

Figur 3

$i_{\text{OA-th}} + i_{\text{R-th}}$

$I_{\text{in}}$

**Figur 4**

1: 100GOhm (Fig. 1a)
2: 100GOhm +Ⓢ (Fig. 1b)
3: 2 x 50GOhm +Ⓢ (Fig. 1d, Fig. 2)
4: 2 x 50GOhm +Ⓢ (Fig. 1e, Fig. 3)

**Figur 5**

Europäisches
Patentamt

European
Patent Office

Office européen
des brevets

**EUROPÄISCHER RECHERCHENBERICHT**

Nummer der Anmeldung

EP 14 00 2394

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 4 586 008 A (RALEIGH MICHAEL [US]) 29. April 1986 (1986-04-29) * Spalte 2, Zeile 16 - Spalte 3, Zeile 15; Abbildungen 1,3 * ----- | 1-11 | INV. H01C1/06 |
| X | GB 2 032 191 A (WELWYN ELECTRIC LTD) 30. April 1980 (1980-04-30) | 1-3 | |
| A | * das ganze Dokument * ----- | 5-8,11 | |
| X | EP 1 538 641 A2 (EPCOS AG [DE]) 8. Juni 2005 (2005-06-08) | 1-4 | |
| A | * Absätze [0022], [0023], [0031]; Abbildungen 1D-3 * ----- | 7,8 | |
| X | US 6 388 863 B1 (HORIE KENICHI [JP]) 14. Mai 2002 (2002-05-14) | 1-4 | |
| A | * Spalten 1,5; Abbildungen 2,4,8 * ----- | 7,8 | |

| RECHERCHIERTE SACHGEBIETE (IPC) |
|---|
| H01C G01R |

Der vorliegende Recherchenbericht wurde für alle Patentansprüche erstellt

| Recherchenort | Abschlußdatum der Recherche | Prüfer |
|---|---|---|
| München | 28. November 2014 | Roesch, Guillaume |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                EP 14 00 2394

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-11-2014

| Im Recherchenbericht angeführtes Patentdokument | | Datum der Veröffentlichung | Mitglied(er) der Patentfamilie | | Datum der Veröffentlichung |
|---|---|---|---|---|---|
| US 4586008 | A | 29-04-1986 | KEINE | | |
| GB 2032191 | A | 30-04-1980 | KEINE | | |
| EP 1538641 | A2 | 08-06-2005 | AT | 510289 T | 15-06-2011 |
| | | | DE | 10356498 A1 | 07-07-2005 |
| | | | EP | 1538641 A2 | 08-06-2005 |
| | | | EP | 2246866 A1 | 03-11-2010 |
| | | | ES | 2366782 T3 | 25-10-2011 |
| US 6388863 | B1 | 14-05-2002 | EP | 1110312 A1 | 27-06-2001 |
| | | | JP | 4993800 B2 | 08-08-2012 |
| | | | JP | 2000357632 A | 26-12-2000 |
| | | | TW | 457538 B | 01-10-2001 |
| | | | US | 6388863 B1 | 14-05-2002 |
| | | | WO | 0077927 A1 | 21-12-2000 |

EPO FORM P0461

Für nähere Einzelheiten zu diesem Anhang : siehe Amtsblatt des Europäischen Patentamts, Nr.12/82